# EUROPÄISCHE PATENTANMELDUNG

(11) **EP 2 466 753 A1**
(43) Veröffentlichungstag der Anmeldung: **20.06.2012**
(21) Anmeldenummer: 11189958.9
(22) Anmeldetag: 21.11.2011
(51) Int. Cl.: H03K 17/567, H03K 17/687

(54) **Widerstandsschaltung, Schaltungsanordnung und Treiber**

(30) Priorität: 16.12.2010 DE 102010063269
(71) Anmelder: SEMIKRON Elektronik GmbH & Co. KG, 90431 Nürnberg (DE); Fraunhofer-Gesellschaft zur Förderung der angewandten Forschung e.V., 80686 München (DE)
(72) Erfinder: Berberich, Sven, Dr., 91080 Spardorf (DE); Erlbacher, Tobias, Dr., 91099 Poxdorf (DE); Wintrich, Arendt, Dr., 90766 Fürth (DE)
(74) Vertreter: Mörtel & Höfner

(57) **Zusammenfassung**

Bei einer Widerstandsschaltung (2), mit zwei Anschlussklemmen (4a,b) und einer zwischen diesen anliegenden Spannung (U), und mit mindestens zwei, zwischen den Anschlussklemmen (4a,b) parallel geschalteten, jeweils mindestens einen ohmschen Widerstand (Ra-c) enthaltenden Zweigen (6a-c), ist mindestens einer der Zweige (6a-c) als selbstschaltender Schaltzweig (8b,c) ausgebildet, der ein in Reihe zum Widerstand (Ra-c) geschaltetes, selbstschaltendes Begrenzungselement (9b,c) enthält, das einen Stromfluss für eine Spannung unterhalb oder oberhalb einer dem Schaltzweig (8b,c) zugeordneten Grenzspannung (Ub,c) verhindert, und der ein in Reihe zum Widerstand (Ra-c) geschaltetes Sperrelement (10b,c) enthält, das einen Stromfluss entgegen einer Flussrichtung (12b,c) im Schaltzweig (8b,c) verhindert.

Eine Schaltungsanordnung (18) mit einem Transistor (24) enthält zwischen einem Steuereingang (26) des Transistors (24) und ihrem Eingang (20) eine o.g. Widerstandsschaltung (2).

Ein Treiber (28) für einen Leistungshalbleiterschalter (32) enthält eine ihrem Steuerausgang (30) vorgeschaltete o.g. Widerstandsschaltung (2).

## Beschreibung

Die Erfindung betrifft eine Widerstandsschaltung, eine, einen Transistor enthaltende Schaltungsanordnung und einen Treiber für einen Leistungshalbleiterschalter.

Die Wahl eines ohmschen Widerstandes in einer elektrischen Schaltung stellt in vielen Fällen eine Kompromisslösung dar. Lediglich beispielhaft sei hier die Dimensionierung eines Vorwiderstandes für die Beschaltung des Steuereingangs eines Transistors genannt. Im Bereich der Leistungselektronik werden Transistoren auch als Leistungshalbleiterschalter bezeichnet. Hier wird dann z.B. das Gate eines IGBT über den Widerstand angesteuert. Das Gate wird hierbei von einer Treiberschaltung, kurz Treiber, angesteuert. Der Widerstand ist in der Regel ausgangsseitig im Treiber integriert.

Im Folgenden wird als Beispiel eine IGBT-Ansteuerung erläutert. Einerseits sind hier kleine Schaltverluste des IGBT anzustreben, was die Verwendung eines kleinen Widerstandswertes notwendig macht. Andererseits sind möglichst niedrige Steilheiten der Strom- und Spannungsschaltkurven sowie kleine Schaltspitzen erstrebenswert, was große Widerstandswerte notwendig macht.

Bekannt ist die Wahl eines einzigen Widerstands. Hier ist bei der Dimensionierung des Widerstandswertes ein Optimum in Form eines Kompromisses mit einem einzigen Festwiderstand zu finden.

Bekannt ist es alternativ, zumindest für das Ein- und Ausschalten eines entsprechenden Leistungshalbleiterschalters zwei verschiedene ohmsche Widerstände vorzusehen, welche dann aus zwei verschiedenen Zweigen einer Endstufe eines Treibers angesteuert werden.

Aus der DE 197 40 540 C1 ist es bekannt, zwei Widerstände in zwei Zweigen durch eine einzige Endstufe anzusteuern. Einschalt- und Ausschaltzweig weisen hierbei jeweils eine Diode auf, deren Durchlassrichtungen entgegengesetzt orientiert sind. Die Dioden verhindern im jeweiligen Zweig jeweils einen Stromfluss entgegen der Flussrichtung der jeweiligen Diode. So ist im Ein- oder Ausschaltfall nur einer der Zweige stromdurchflossen bzw. der jeweilige dortige Widerstand aktiv.

Insbesondere für Anwendungen im größeren Leistungsbereich sowie bei Notabschaltungen ist außerdem ein mehrstufiges Abschalten bekannt, um den oben genannten Widerspruch wenigstens teilweise zu lösen. Hier werden alleine beim Ausschalten über mehrere Treiberendstufen je nach Schaltzustand verschiedene Festwiderstände zeitlich hintereinander zugeschaltet. Unkritische Zeitbereiche im Schaltvorgang werden dabei schnell mit einem kleinen Widerstandswert durchfahren, um dort geringe Schaltverluste zu verursachen. In kritischen Zeitbereichen wird die Schaltgeschwindigkeit durch die Umschaltung auf Zweige mit großen Widerstandswerten reduziert, um einen sicheren Betrieb zu garantieren.

Das bekannte mehrstufige Schalten beziehungsweise dessen Realisierung auf einer Leiterplatte eines Treibers erfordert mehrere Treiberendstufen anstelle einer einzigen. Jede Treiberendstufe ist dabei über einzelne Festwiderstände mit unterschiedlichen Widerstandswerten auf das Gate geführt. Außerdem ist eine zusätzliche Logikschaltung notwendig, welche zeitabhängig und/oder spannungsabhängig in zeitlicher Abfolge die verschiedenen Treiberendstufen aktiviert, um den Schalteingang des Leistungshalbleiters über verschiedene Festwiderstandswerte zu betreiben. Hinzu kommt das Problem, dass auf einer derartigen Leiterplatte das zum Gate führende Schaltsignal bereits durch parasitäre Einstreuungen gestört ist. Eine spannungsabhängige Steuerung des Zu- und Abschaltens verschiedener Festwiderstandswerte ist daher generell nicht oder nur sehr ungenau möglich. Hinzu kommt, dass Gate-Widerstände auf Leiterplatten Verluste - in Form von Abwärme - verursachen, die dort nur schlecht abgeführt werden können.

Leistungshalbleitermodule größerer Leistung vereinen viele parallel geschaltete Leistungshalbleiterchips in einem Modul. Verschiedene integrierte Einzelwiderstände würden hier mehrere Ansteueranschlüsse erfordern, was aus Gründen der Zuverlässigkeit und aus Kostengründen für Leistungsmodule nicht praktikabel ist. Eine für ein synchrones Schalten notwendige Einzelbeschaltung der Chips ist daher hier nicht möglich In einem derartigen Modul integrierte Gate-Vorwiderstände sind daher als Festwerte auch nicht einstellbar.

Aus der DE 101 51 700 B4 ist eine Schaltung bekannt, bei der ein Widerstandselement drei parallele Zweige aufweist. Einer der Zweige ist ein stets einen Stromfluss erlaubender Durchflusszweig, d.h. im Ein- und Ausschaltfall aktiver Zweig. Zwei weitere Zweige sind selbstschaltende Schaltzweige und enthalten jeweils mehrere in Durchflussrichtung betriebene Zenerdioden. Diese erfüllen eine Doppelfunktion. Die summierten Durchlassspannungen ergeben eine Grenzspannung für den jeweiligen Zweig, unterhalb derer ein Stromfluss darin verhindert ist. Die Durchlassrichtung der Zenerdioden gibt überhaupt die Flussrichtung im Zweig vor. Die Zenerdioden in den beiden Zweigen sind wieder entgegengesetzt orientiert, um einen Ein- und Ausschaltzweig zu definieren. Die Doppelfunktion der Zenerdioden besteht darin, dass diese in Sperrrichtung, einen Schutz vor Stoßspannungen bewerkstelligen. Hier wirken dann die jeweiligen Zenerspannungen als Grenzspannungen.

Ein alternativer Schaltzweig, der in beiden Stromrichtungen aktiv ist und einen Stromfluss erst oberhalb einer Grenzspannung erlaubt, ist aus der EP 0 631 390 A2 bekannt.

Realisierungen von ohmschen Widerständen mit entsprechenden o.g. variablen Eigenschaften werden also in Form von Widerstandsschaltungen realisiert, die in der Regel mehrere parallele Schaltzweige mit Widerständen und weitere Beschaltungselemente enthalten.

Aufgabe der vorliegenden Erfindung ist es, eine verbesserte Widerstandsschaltung, sowie eine verbesserte, einen Transistor enthaltende Schaltungsanordnung, und einen verbesserten Treiber für einen Leistungshalbleiterschalter anzugeben.

Hinsichtlich der Widerstandsschaltung wird die Aufgabe gelöst durch eine Widerstandsschaltung gemäß Patentanspruch 1, welche genau zwei Anschlussklemmen - zwischen denen eine Spannung anliegt - und mindestens zwei, zwischen den Anschlussklemmen parallel geschaltete Zweige enthält. Jeder Zweig enthält mindestens einen ohmschen Widerstand. Mindestens einer der Zweige ist als selbstschaltender Schaltzweig ausgebildet. Der Schaltzweig enthält ein in Reihe zum Widerstand geschaltetes Begrenzungselement. Das Begrenzungselement erfüllt folgende Funktionalität selbstschaltend: Das Begrenzungselement ist so ausgebildet, dass es einen Stromfluss - durch das Begrenzungselement - dann verhindert, wenn die Spannung unterhalb oder oberhalb einer dem Schaltzweig zugeordneten Grenzspannung liegt. Mit anderen Worten sind genau zwei Arten von Begrenzungselementen denkbar. Die eine Art erlaubt Stromfluss oberhalb, und die andere Art unterhalb der Grenzspannung.

Der Schaltzweig enthält außerdem ein in Reihe zum Widerstand geschaltetes, einen Stromfluss im Schaltzweig entgegen einer Flussrichtung verhinderndes Sperrelement.

Durch die Beeinflussung der Flussrichtung im Schaltzweig wird erreicht, dass die betreffende Schalteigenschaft des Schaltzweiges nur für eine der beiden möglichen Stromflussrichtung durch die Widerstandsschaltung wirksam wird. In der Gegenrichtung ist der entsprechende Schaltzweig hochohmig und geht damit bei der Grenzspannung nicht widerstandsverändernd in den Gesamtwiderstand ein. Für verschiedene Stromflussrichtungen können so verschiedene ohmsche Widerstandscharakteristiken der Widerstandsschaltung erreicht werden.

Als Sperrelement kommt in der Regel eine die Flussrichtung bestimmende Diode zum Einsatz. Diese rein elektrisch arbeitende Lösung bereitet in der Regel keine Schwierigkeiten mit Materialermüdung auf Grund von mehreren Milliarden Schaltzyklen. Ferner ist kein zusätzlicher Aufwand für die Ansteuerung nötig, da das Bauelement als Zweipol ausgeführt ist, der ohne eine zusätzliche Beschaltung eine entsprechende Ansteuerkurve vorgibt beziehungsweise beinhaltet. Geeignet sind z.B. Schottky-Dioden oder pn-Dioden.

Je nach Wahl der Begrenzungs- und Sperrelemente lässt sich ein symmetrisches Schaltverhalten für betragsgleiche, aber vorzeichenunterschiedliche Spannungen realisieren, welche bei höheren Spannungsdifferenzen einen niedrigen Widerstandswert aufweisen. Durch unterschiedliche Grenzspannungen in Schaltzweigen unterschiedlicher Flussrichtung lassen sich auch Schaltspannungen bei positiven und negativen Spannungen unterschiedlich wählen und somit unterschiedlich verlaufende Widerstandscharakteristika über den Spannungsbeträgen realisieren. Ebenso ist eine unabhängige Realisierung verschiedener Widerstandswerte möglich.

Die Erfindung beruht auf der grundlegenden Idee, einen bisher als Kompromiss gewählten einzigen Festwiderstand durch einen Zweipol in Form der Widerstandsschaltung zu ersetzen, welcher verschiedene Widerstandswerte annehmen kann. Der Widerstandswert soll sich abhängig von der zwischen beiden Polen angelegten Spannung selbsttätig verändern, d.h. ohne zusätzliche Ansteuerung von außen.

Die Erfindung beruht auf der Erkenntnis, dass sich der ohmsche Widerstandswert der Widerstandsschaltung bei Über- oder Unterschreiten eines bestimmten Spannungsniveaus ändern soll. Dieses Merkmal wird durch das Begrenzungselement bewerkstelligt, welches für Spannungen unterhalb oder oberhalb einer Grenzspannung einen Stromfluss durch das Begrenzungselement verhindert. So entsteht ein Schaltelement für den betreffenden Schaltzweig, das abhängig von der Spannung am Widerstandselement schaltet. Durch eine geeignete Verschaltung des Begrenzungselements und u.U. weiterer Elemente können so in weiten Bereichen beliebige Widerstandscharakteristiken des Zweipols über der an diesem anliegenden Spannung erreicht werden.

Beispielsweise enthält der Schaltzweig nur den Widerstand und in Reihenschaltung das Begrenzungselement und das Sperrelement. Der Schaltzweig wird dann durch das Sperrelement einer eindeutigen Stromrichtung zugeordnet. Bei Anliegen dieser Stromrichtung wird der Schaltzweig aber dann erst ab oder unterhalb einer bestimmten Spannung den restlichen Zweigen des Widerstandselements parallel zu- oder abgeschaltet. Z.B. wird erst bei Überschreiten der Grenzspannung der entsprechende Schaltzweig zugeschaltet und der Widerstandswert im Schaltzweig einem bereits vorhandenen Widerstandswert in einem anderen Zweig parallel geschaltet. So nimmt der wirksame Widerstand zwischen den Anschlussklemmen ab. Durch Austausch gegen ein alternatives, ab der Grenzspannung sperrendes Begrenzungselement wird der Widerstand dagegen bei steigender Spannung zunehmen, wenn der Schaltzweig aus der Parallelschaltung fällt.

Die erfindungsgemäße Lösung stellt ein passives Bauelement mit zwei Anschlüssen dar, welches gängige zweipolige Widerstandselemente direkt ersetzen kann und ohne zusätzliche, aufwendige externe Ansteuerung auskommt.

Erfindungsgemäß werden also nichtlineare spannungsabhängige Widerstandswerte dadurch erzeugt, dass - im Sinne einer fehlenden Ansteuerung von außerhalb des Widerstandselements - passive Bauelemente geeignet verschaltet werden. Insbesondere kommen ohmsche Widerstände, und als Begrenzungselemente z.B. Zenerdioden oder selbstleitende Transistoren, d.h. in einer Beschaltung ohne externe Ansteuerung, zum Einsatz. Je nach Dimensionierung und Verschaltung dieser Bauelemente lässt sich das nichtlineare Widerstandsverhalten der Widerstandsschaltung festlegen. Bei einer definierten Spannung über der Widerstandsschaltung liegen auch definierte Widerstandswerte vor.

Je nach Wahl der Bauelemente lässt sich ein Schaltverhalten realisieren, welches beim Überschreiten von Spannungsgrenzen zu einem niedrigeren oder höheren Widerstandswert übergeht. Durch unterschiedliche Grenzspannungen in unterschiedlichen Schaltzweigen lassen sich auch mehrstufige Widerstandscharakteristika über der anliegenden Spannung realisieren.

Gemäß einer bevorzugten Ausführungsform ist im Schaltzweig dem Begrenzungselement ein zusätzlicher ohmscher Widerstand parallel geschaltet. So wird aus dem Begrenzungselement ein Null-Ohm-Bypass für den zusätzlichen Widerstand, bereits innerhalb des Schaltzweiges eine Realisierung von zwei, je nach Spannung unterschiedlichen, von Null und Unendlich verschiedenen Widerstandswerten erlaubt.

Gemäß einer bevorzugten Ausführungsform ist im Schaltzweig auch dem Sperrelement oder dessen Reihenschaltung mit dem Begrenzungselement ein zusätzlicher ohmscher Widerstand parallel geschaltet. So wird die o.g. Null-Ohm-Bypass-Funktion ebenfalls abhängig von der Stromflussrichtung durch das Widerstandselement.

In einer weiteren bevorzugten Ausführungsform weist die Widerstandsschaltung mindestens zwei Schaltzweige auf, die bezüglich der Anschlussklemmen gegensinnig orientierte Flussrichtungen aufweisen. So existiert in der Widerstandsschaltung z.B. neben einem immer wirksamen Durchflusszweig mit konstantem Widerstandswert für beide möglichen Durchflussrichtungen eines elektrischen Stromes zusätzlich in jeder Richtung die Möglichkeit, durch mindestens einen Schaltzweig, d.h. ein selbstschaltendes Begrenzungselement abhängig von richtungsabhängigen Grenzspannungen den Widerstandswert der Widerstandsschaltung zu beeinflussen.

In einer bevorzugten Ausführungsform ist das Begrenzungselement eine die Grenzspannung durch ihre Zenerspannung bestimmende Zenerdiode. Im Vergleich zu Lösungen, die auf der Verwendung von mechanischen oder piezoelektrischen Schaltern als Umschalter für unterschiedliche Widerstände dienen, sind bei der vorgeschlagenen, rein elektrisch arbeitenden Lösung keine Schwierigkeiten mit Materialermüdung auf Grund von mehreren Milliarden Schaltzyklen zu erwarten. Ferner ist kein zusätzlicher Aufwand für die Ansteuerung nötig, da das Begrenzungselement als Zweipol ausgeführt ist, der ohne eine zusätzliche Beschaltung eine entsprechende Ansteuerkurve vorgibt beziehungsweise beinhaltet.

Wesentlich ist hierbei, dass die Zenerdiode mit dem Sperrelement derart verschaltet ist, dass diese nur in ihrer Sperrrichtung von Strom durchflossen wird. So wirkt die Zenerdiode stets nur mit ihrer Zenerspannung als Begrenzungselement. Die Durchflussrichtung der Zenerdiode wird nicht benutzt, da hier das Sperrelement ohnehin einen Stromfluss im Schaltzweig verhindert. Ist das Sperrelement z.B. eine Schottkydiode, so sind diese und die Zenerdiode in Reihenschaltung mit entgegengesetzten Durchlassrichtungen verschaltet. Die Höhe der Durchlassspannung einer Zenerdiode ist auf ca. 0,7V festgelegt. Die Höhe der Zenerspannung kann bei Zenerdioden dagegen in weiten Grenzen wählbar hergestellt werden. Da die Zenerdioden erfindungsgemäß in Sperrrichtung betrieben wird, muss so, um z.B. eine Grenzspannung von 7V zu erreichen, erfindungsgemäß lediglich eine einzige Zenerdiode im Schaltzweig mit einer Zenerspannung von 7V vorgesehen werden. Würde die Zenerdiode in Durchlassrichtung betrieben, wären hier zehn serielle Zenerdioden nötig.

Zunächst ergibt sich anhand der Erfindung gegenüber der bekannten o.g. Lösung gemäß DE 101 51 700 B4 ein scheinbarer Zusatzaufwand, da dort alleine Zenerdioden, hier noch zusätzlich ein Sperrelement nötig ist. Es ergibt sich dann jedoch durch die Erfindung der Effekt, dass durch das Sperrelement ein Umdrehen der Zenerdiode und die Nutzung der Zenerspannung als Grenzspannung möglich wird und so die Anzahl der nötigen Zenerdioden zur Erreichung der selben Grenzspannung auf eine einzige gesenkt werden kann.

Durch eine Reihenschaltung einer Zenerdiode mit einem Widerstand und die passende Wahl des Widerstandsmaterials kann eine Temperaturdrift der Widerstandsschaltung nahezu eliminiert werden.

In einer weiteren Ausführungsform ist das Begrenzungselement ein die Grenzspannung bestimmender selbstleitender Transistor. Auch hier gilt das oben gesagte bezüglich der Schaltzyklen usw. In Frage kommt z.B. ein selbstleitender p-Kanal-MOSFET ohne externe Gateansteuerung und mit geeigneter Verschaltung im 2-Pol Netzwerk.

Der Transistor benötigt innerhalb der Widerstandsschaltung eine Steuerleitung, die an einem Punkt der Widerstandsschaltung angeschlossen ist. Hierzu kann z.B. einer der Anschlüsse genutzt werden. So kann z.B. erreicht werden, dass die gesamte Spannung über der Widerstandsschaltung für die Ansteuerung des Transistors genutzt wird. Die Festlegung der Grenzspannung wird dann alleine durch die Transistorcharakteristik beeinflusst. Die Steuerleitung des Transistors kann aber auch an einem Punkt im Inneren der Schaltung angreifen. Hier kann über einen Spannungsteiler auch eine zur Spannung geteilte Teilspannung genutzt werden. Dies bewirkt einen weiteren Freiheitsgrad für die Wahl der Grenzspannung bei einer gegebenen Transistorcharakteristik.

Gemäß einer vorteilhaften Ausführungsform ist mindestens einer der Zweige als stets einen Stromfluss erlaubender Durchflusszweig ausgebildet. Der Durchflusszweig ist mit seinem Widerstand stets wirksam, d.h. die Widerstandsschaltung weist zunächst in beiden Flussrichtungen einen immer vorhandenen Basiswiderstand auf. Dieser wird durch Einwirkung der parallel geschalteten Schaltzweige spannungs- und richtungsabhängig modifiziert.

In einer bevorzugten Ausführungsform ist die Widerstandsschaltung als monolithisch integrierter Halbleiterchip ausgeführt. Durch eine kostengünstige Integrationsmöglichkeit als z.B. bond- und lötbarer Halbleiterchip kann für die Widerstandsschaltung eine höhere Zuverlässigkeit erzielt werden, als dies mit diskreten Einzelbauelementen erzielbar wäre. Insbesondere können so gängige SMD-Lösungen für Widerstände bzw. Widerstandsschaltungen direkt durch Einsetzen eines erfindungsgemä-βen Chips ersetzt werden.

Durch die monolithische Integration eines nicht linearen spannungsabhängigen Widerstandes, z.B. als Gatevorwiderstand, können weitere Vorteile erreicht werden: Beispielsweise ist so die Integration der Widerstandsschaltung direkt in den Leistungsteil einer Leistungshalbleiterschaltung möglich. Hierdurch werden parasitäre Elemente reduziert und die Zuverlässigkeit erhöht, da nur ein einziges Bauelement in einer Standard-Aufbau- und -Verbindungstechnik - wie z.B. Löten und Sintern - aufgebaut wird. Außerdem lassen sich somit hohe Stückzahlen kostengünstig und flächenoptimal realisieren, wobei zusätzlich eine hohe Bauelementezuverlässigkeit gewährleistet werden kann.

Die Integration bietet außerdem die Möglichkeit, eine Reihenschaltung aus Sperrelement und Begrenzungselement besonders günstig zu integrieren. Einer integrierten Zenerdiode braucht hier nur ein Schottkykontakt aufgepflanzt zu werden, um eine Reihenschaltung von Zenerdiode und Schottkydiode zu realisieren. Es ergibt sich also eine einfache Integrierbarkeit bzw. Kombinierbarkeit von Zener- und Schottkydioden.

Hinsichtlich der Schaltungsanordnung wird die Aufgabe der Erfindung gelöst durch eine Schaltungsanordnung gemäß Patentanspruch 9 mit einem Eingang und zwei Ausgängen. Zwischen den beiden Ausgängen ist ein Transistor bezüglich seiner Anschlüsse Emitter und Kollektor verschaltet. Zwischen einem Steuereingang des Transistors, also Basis oder Gate, und dem Eingang ist erfindungsgemäß eine oben erläuterte Widerstandsschaltung angeschlossen. Die Widerstandsschaltung fungiert damit in der Schaltungsanordnung als modifizierter Gate- beziehungsweise Basis-Vorwiderstand für den Transistor. Insbesondere wenn der Transistor ein Leistungshalbleiterschalter ist, kann so das oben genannte Optimum erzielt werden:

Einerseits können kleine Schaltverluste und - in ausgewählten Bereichen - möglichst niedrige Steilheiten von Strom- und Spannungskurve erreicht werden. Andererseits können kleine Schaltspitzen erreicht werden. Für die kleinen Schaltverluste ist ein kleiner Widerstandswert erforderlich, für die kleinen Schaltspitzen und die niedrigen Strom- und Spannungssteilheiten ein großer Widerstandswert. Die Erfindung beruht hier auf der Erkenntnis, dass im Bezug auf den zeitlichen Verlauf der Gatespannung beim Laden der Gatekapazität, also beim Einschalten des Leistungsschalters das Miller-Plateau möglichst schnell erreicht werden soll. Dies soll durch die Wirksamkeit eines kleinen Gatewiderstandswertes erreicht werden. Zu einem späteren Zeitpunkt soll mit einem großen Gatewiderstandswert weiter verfahren werden.

Beim Ausschalten soll zunächst ein schneller Anstieg der Spannung durch kleine Widerstandswerte erreicht werden, um die dynamischen Schaltverluste klein zu halten. Ab einem definierten Spannungsniveau soll dann ein größerer Widerstandswert Verwendung finden, um die Schaltüberspannung zu begrenzen.

Die Erfindung beruht weiterhin auf der Erkenntnis, dass sowohl beim Ein- als auch beim Ausschaltvorgang der Betrag der jeweiligen Spannung über dem Vorwiderstand stets abnimmt, wobei der Widerstandswert hierbei stets zunehmen soll. Eine entsprechende Schaltcharakteristik lässt sich genau durch die erfindungsgemäße Widerstandsschaltung und damit in der erfindungsgemäßen Schaltungsanordnung realisieren.

Da das erfindungsgemäße Bauelement als Zweipol ausgeführt ist, benötigt es in der Schaltungsanordnung keine zusätzliche äußere Beschaltung. Wird das erfindungsgemäße Bauelement als monolithisch integrierter Halbleiterchip ausgeführt, kann dieser in den Leistungsteil eines Leistungsmoduls integriert werden. Das Leistungsmodul stellt dann die Schaltungsanordnung dar. Insbesondere können somit auch die Aufbau- und Verbindungstechnologien des Leistungsmoduls verwendet werden.

In einer bevorzugten Ausführungsform ist also der Transistor ein Leistungshalbleiterschalter. Insbesondere hier treten die oben genannten Vorteile zu Tage.

In einer weiteren bevorzugten Ausführungsform ist zwischen den beiden Ausgängen der Transistor als erster Transistor mit einem zweiten Transistor nach Art einer Halbbrücke verschaltet. Auch der zweite Transistor weist dann die erfindungsgemäße Widerstandsbeschaltung auf. Diese kann für beide Transistoren der Halbbrücke identisch, gleich oder unterschiedlich sein.

Hinsichtlich des Treibers wird die Aufgabe gelöst durch einen Treiber gemäß Patentanspruch 12 mit einem Steuerausgang, welcher mit einem Steuereingang eines Leistungshalbleiterschalters verbindbar ist. Im Treiber ist dem Steuerausgang eine erfindungsgemäße Widerstandsschaltung vorgeschaltet.

Somit lassen sich die oben genannten Vorteile der erfindungsgemäßen Widerstandsschaltung in einem Treiber für einen Leistungshalbleiterschalter mit den oben genannten Vorteilen realisieren. Der nichtlineare spannungsabhängige GateVorwiderstand ermöglicht damit eine gezielte Beeinflussung des Schaltverhaltens von Leistungshalbleiterbauelementen. Durch eine geeignete Dimensionierung des Gatevorwiderstandes kann der Leistungsschalter im Gegensatz zum Einsatz eines Widerstandes mit festem Wert schneller ein- und ausgeschaltet werden, ohne die Betriebssicherheit und die elektromagnetische Verträglichkeit zu gefährden.

Für eine weitere Beschreibung der Erfindung wird auf die Ausführungsbeispiele der Zeichnungen verwiesen. Es zeigen, jeweils in einer schematischen Prinzipskizze:
- Fig. 1: eine erfindungsgemäße Widerstandsschaltung,
- Fig. 2: ein Widerstands-Spannungsdiagramm der Schaltung aus Fig. 1,
- Fig. 3: ein Strom-Spannungsdiagramm zu Fig. 2,
- Fig. 4: ein Widerstands-Spannungsdiagramm der alternativ dimensionierten Schaltung aus Fig. 1,
- Fig. 5: ein Strom-Spannungsdiagramm zu Fig. 4,
- Fig. 6: eine erfindungsgemäße Schaltungsanordnung,
- Fig. 7: einen erfindungsgemäßen Treiber,
- Fig. 8: die zeitlichen Verläufe verschiedener elektrischer Größen aus Fig. 6,
- Fig. 9: eine alternative Widerstandsschaltung mit Durchflusszweig mit Bypassfunktion,
- Fig. 10: eine Widerstandsschaltung gemäß Fig. 1 mit alternativem Begrenzungselement,
- Fig. 11: eine Widerstandsschaltung gemäß Fig. 9 mit alternativem Begrenzungselement,
- Fig. 12: ein Widerstands-Spannungsdiagramm der Widerstandsschaltung aus Fig. 11.

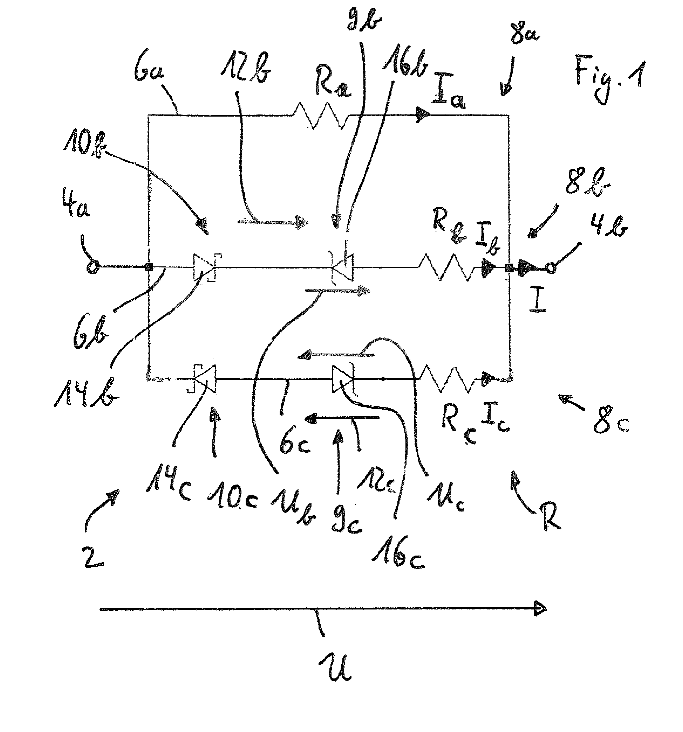

Fig. 1 zeigt eine Widerstandsschaltung 2, welche zwei Anschlussklemmen 4a, b aufweist. Zwischen den Anschlussklemmen 4a, b sind drei Zweige 6a-c parallel geschaltet, die je einen ohmschen Widerstand Ra-c enthalten. Der Zweig 6a ist ein Durchflusszweig 8a. Durch diesen fließt stets ein Strom Ia, sobald zwischen den Anschlussklemmen 4a,b eine von Null verschiedene Spannung U anliegt. Die Zweige 6b,c sind als selbstschaltende Schaltzweige 8b,c ausgebildet. Diese enthalten in Reihe zu den Widerständen Rb beziehungsweise Rc geschaltet je ein Begrenzungselement 9b,c und ein Sperrelement 10b, c. Jedes der Sperrelemente 10b,c definiert eine Flussrichtung 12b,c im entsprechenden Schaltzweig 8b,c. Ein Strom Ib,c kann im Schaltzweig 8b,c nur in die jeweilige Flussrichtung 12b,c fließen. Im Schaltzweig 8b können also nur Ströme Ib>0 im Schaltzweig 8c nur Ströme Ic<0 fließen. Somit sind die möglichen Stromrichtungen für die Begrenzungselement 9b,c eindeutig in einer einzigen Richtung definiert. Nur in dieser Richtung ist jeweils ein Stromfluss durch diese möglich. Das Begrenzungselement 9b,c definiert außerdem für jeden Schaltzweig 8b,c eine Grenzspannung Ub,c. Ströme Ib,c können in den Schaltzweigen 8b,c nur dann fließen, wenn dort an der entsprechenden Stelle Spannungen auftreten, welche größer der Grenzspannungen Ub,c sind. Die Flussrichtungen 12b,c der Schaltzweige 8b,c sind bezüglich der Anschlussklemmen 4a,b gegensinnig orientiert.

Im Ausführungsbeispiel sind die Begrenzungselemente 9b,c jeweils als Zweipole ausgebildet, nämlich jeweils als eine die Grenzspannung Ub,c bestimmende Zenerdiode 16b,c. Die möglichen Stromrichtungen durch die Zenerdioden 16b,c sind durch die Sperrelement 10b,c festgelegt. Die Zenerdioden 16b,c sind so orientiert, dass sie bei einem Stromfluss Ib,c in Sperrrichtung durchströmbar sind. So wirken als die Grenzspannungen Ub,c begrenzende Spannungen die Zenerspannungen der Zenerdioden 16b,c. Deren Durchlassspannungen dagegen kommen nie zur Wirkung, da in dieser Richtung ein Stromfluss im jeweiligen Zweig wegen der Sperrelemente 10b,c verhindert ist. Die Sperrelemente 10b,c sind hierzu in Reihenschaltung als die Flussrichtung 12b,c bestimmende Dioden 14b,c realisiert.

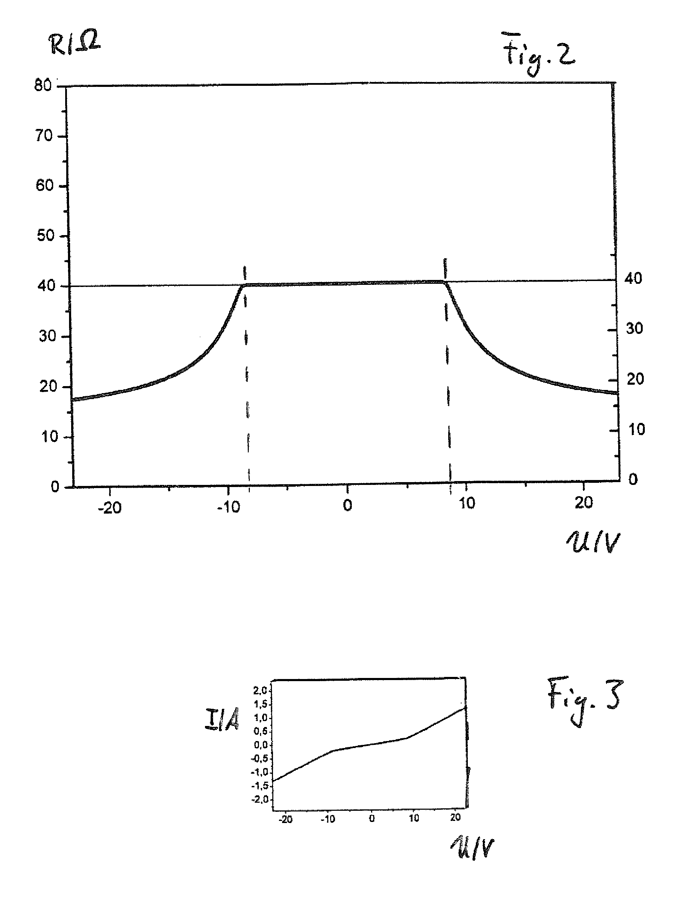

Für die Figuren 2,3 gelten folgende Dimensionierungen der Bauelemente aus Fig.1: Die Widerstandswerte sind Ra = 40Ω, Rb=Rc=18Ω. Die Zener- bzw. Durchbruchspannungen der Zenerdioden 16b,c betragen 8V. Fig. 2 zeigt den zwischen den Anschlussklemmen 4a,b gemessenen Gesamtwiderstand R der Widerstandsschaltung 2 aus Fig. 1 in Ω. Dieser ist aufgetragen über der zwischen den Anschlussklemmen 4a,b abfallenden Spannung U in V. Zu erkennen ist auf Grund der Gleichheit der Widerstände Rb,c und der Zenerspannungen der Zenerdioden 16b,c das symmetrische Verhalten des Widerstandsverlaufs. Im Bereich der Spannung U zwischen etwa -8V und +8V findet keinerlei Stromfluss durch die Schaltzweige 8b,c statt, da die entsprechenden Zenerdioden 16b,c in Zusammenwirkung mit den Dioden 14b,c die Ströme Ib,c sperren. Hier wirkt also alleine der Durchflusszweig 8a.

Bei einer Spannung von U > +8V dagegen wird die Grenzspannung Ub an der Zenerdiode 16b überschritten und die Diode 14b erlaubt einen positiven Stromfluss Ib > 0, wodurch durch den Widerstand Rb ein zusätzlicher Stromfluss erfolgt und dieser als Parallelwiderstand zu Ra den Gesamtwiderstand R der Widerstandschaltung 2 senkt. Gleiches gilt entsprechend für Spannungen U < -8V im Schaltzweig 8c. Mit anderen Worten sind die Bereiche des Widerstandsverlaufs in Fig. 2 jenseits der Spannungen mit Betrag größer als etwa 8V durch die Zenerdioden 16b, c verursacht.

Fig. 3 zeigt den gesamten Strom I durch die Widerstandsschaltung 2 als Summe der Ströme Ia-c, aufgetragen über der Spannung U in V. Auch hier ist die geknickte Kennlinie zu erkennen, die sich an den Schaltpunkten der Schaltzweige 8a,b bei den Spannungsbeträgen von je 8V ergibt.

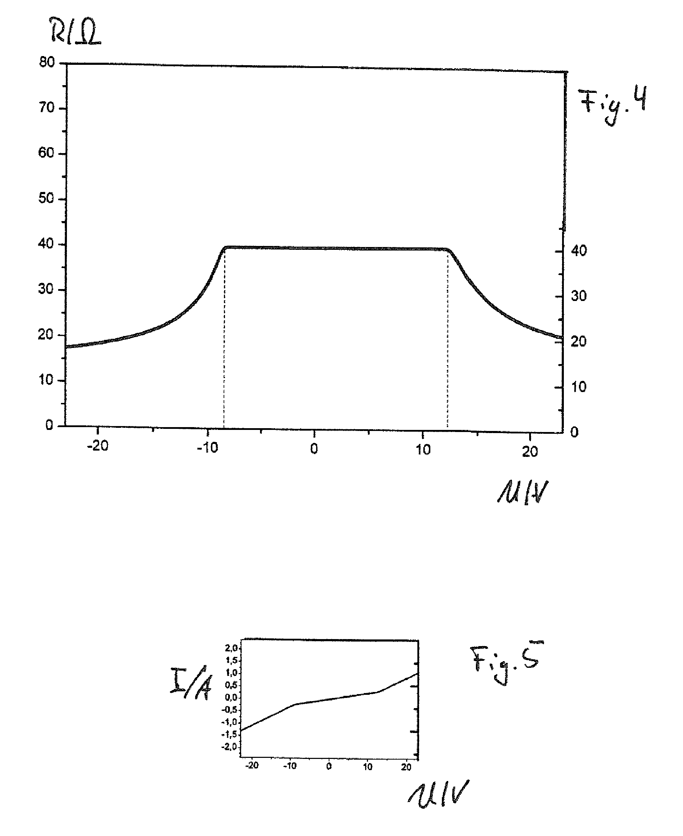

Die Figuren 4 und 5 zeigen entsprechend der Figuren 2 und 3 die gleichen Größen, jedoch für eine veränderte Dimensionierung der Widerstandsschaltung 2 aus Fig. 1. Für die Figuren 4 und 5 gilt ein veränderter Widerstand des Wertes Rb von 8Ω sowie eine veränderte Zenerspannung der Zenerdiode 16b von Ub=12V. Der Schaltzweig 8b erlaubt daher einen Stromfluss erst für Spannungen U > +12V. Auch ist der entsprechende Widerstandsverlauf in Fig. 4 wegen des kleineren Widerstandes Rb von 8Ω verändert gegenüber Fig. 2. Der Ast des Widerstandsverlauf in Fig. 4 für Spannungen kleiner als 0V ist dagegen gleich dem in Fig. 2. Entsprechend ergibt sich auch ein anderer Verlauf des Gesamtstromes I in Fig. 5 über der Spannung U. Der Strom I steigt für positive Spannungen U erst ab einer höheren Grenzspannung von 12V, dafür jedoch steiler als in Fig. 3 an.

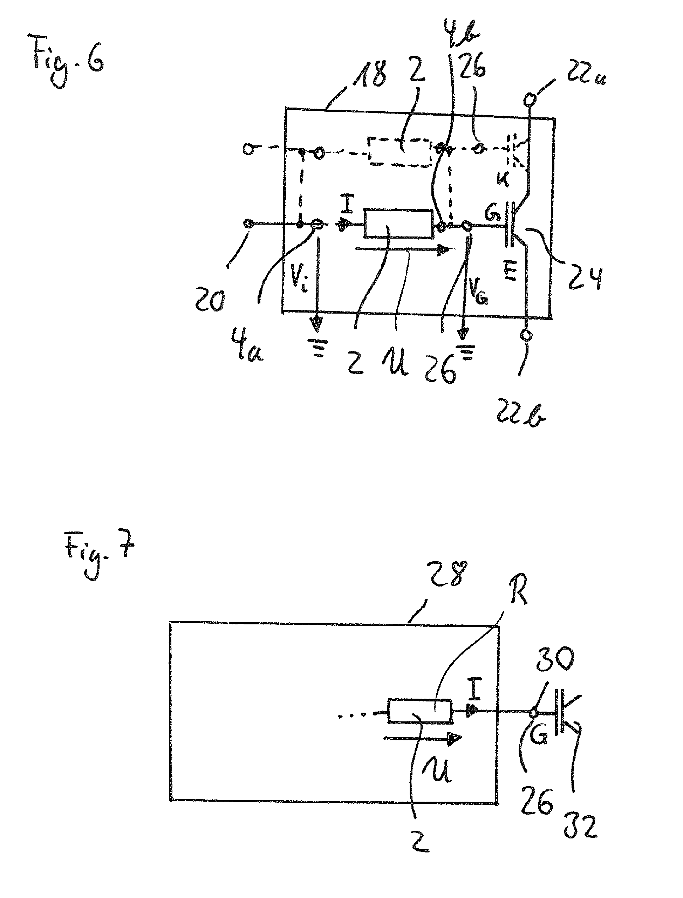

Fig. 6 zeigt eine erfindungsgemäße Schaltungsanordnung 18 mit einem Eingang 20 und zwei Ausgängen 22a,b. Zwischen die Ausgänge 22a,b ist ein Transistor 24 mit seinem Kollektor K und Emitter E verschaltet. Das Gate G des Transistors 24 als dessen Steuereingang 26 ist über die erfindungsgemäße Widerstandsschaltung 2 gemäß Fig. 1 mit dem Eingang 20 verbunden. Mit anderen Worten fungiert in der Schaltungsanordnung 18 die Widerstandsschaltung 2 als ohmscher selbstschaltender Gatevorwiderstand. Der Transistor 24 ist z.B. ein Leistungshalbleiterschalter, z.B. ein IGBT.

In einer bevorzugten Ausführungsform ist in der Schaltungsanordnung 18 ein zweiter, mit dem ersten Transistor 24 verschalteter identischer Transistor enthalten, der lediglich symbolisch gestrichelt angedeutet ist. Beide Transistoren sind entweder parallel, wie dargestellt, oder nach Art einer Halbbrücke verschaltet. Der Steuereingang 26 des weiteren Transistors kann entweder zum Steuereingang 26 des ersten Transistors 24 parallel geschaltet sein und über die gemeinsame, also selbe Widerstandsschaltung 2 angesteuert werden. Denkbar sind jedoch auch Ausführungsvarianten mit einer zweiten, unter Umständen anders dimensionierten Widerstandsschaltung 2, welche dem zweiten Transistor zugeordnet ist und die wiederum über eine gemeinsame Ansteuerung vom selben Eingang 20 angesteuert ist oder in der Halbbrücke eine separate Ansteuerung über einen weiteren, gestrichelt gezeichneten Eingang realisiert ist.

Fig. 7 zeigt einen Treiber 28 für einen Leistungshalbleiterschalter 32. Der Treiber weist einen Steuerausgang 30 auf, der an den Steuereingang 26 des Leistungshalbleiterschalters 32 anschließbar ist. Im Inneren des Treibers 28 ist dem Steuereingang 30 eine erfindungsgemäße Widerstandsschaltung 2 vorgeschaltet. Mit anderen Worten wird ein ansonsten üblicher Festwiderstand oder schaltbarer Widerstand im Inneren des Treibers 28 durch die erfindungsgemäße Widerstandsschaltung 2 ersetzt, welche abhängig von der abfallenden Spannung U oder dem durchfließenden Strom I selbstschaltend ihren Widerstandswert R verändert.

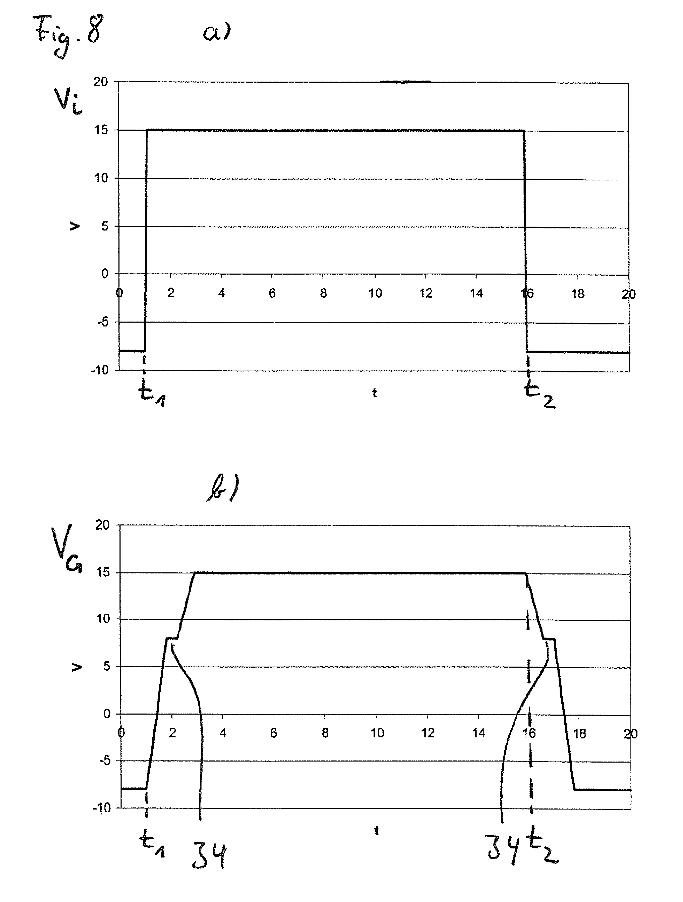

Fig. 8a) zeigt einen Verlauf des Potentials Vi des Anschlusses 4a der Widerstandsschaltung 2 aus Fig. 6 über der Zeit t. Mit anderen Worten ist hier eine Schaltspannung gezeigt, die den Transistor 24 ansteuert. Zum Zeitpunkt t1 erfolgt ein Einschalten des Transistors 24, zum Zeitpunkt t2 ein Ausschalten.

Fig. 8b zeigt entsprechend den Verlauf des Potentials VG des entsprechenden Anschlusses 4b bzw. des Gate G des Transistors 24. Die Spannung U über der Widerstandsschaltung 2 ergibt sich also als U=Vᵢ-V_{G}. Zu erkennen ist sowohl beim Einschaltvorgang nach t1, als auch beim Ausschaltvorgang nach t2 das Miller-Plateau 34.

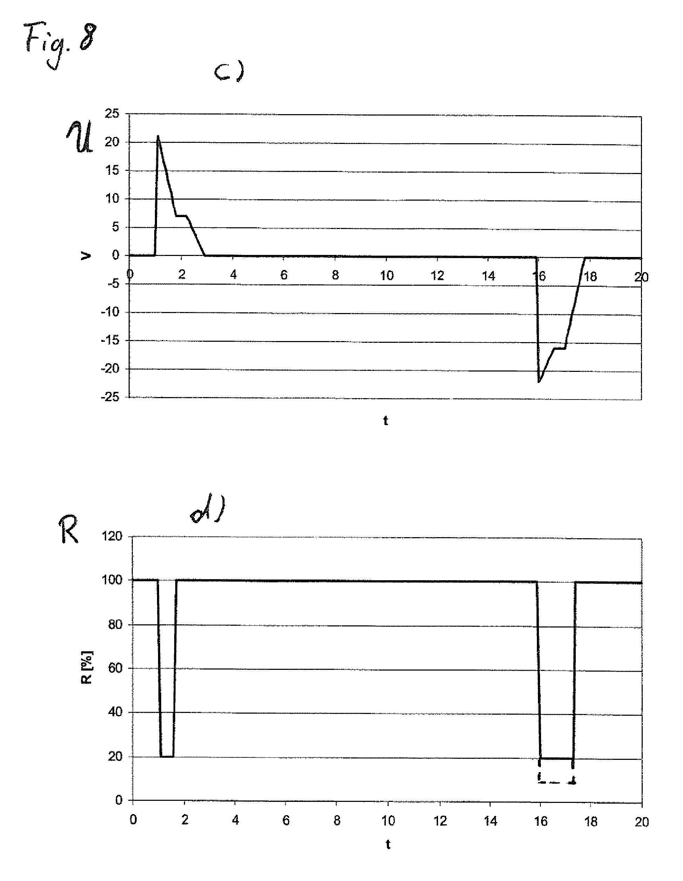

Fig.8c zeigt den Verlauf der Spannung U, die über der Widerstandsschaltung 2 abfällt. Der Widerstand R verändert sich hierbei gemäß der Kennlinie nach Fig. 2 über der Zeit. Hierbei sind unterschiedliche Widerstandsverläufe für Ein- und Ausschaltvorgang zu beobachten, da sich der Spannungsverlauf der Spannung U über der Zeit t unterschiedlich ist.

Fig.8d schließlich zeigt im Detail den Verlauf des relativen Widerstandes R/Ra über der Zeit t. Auch hier sind Unterschiede feststellbar, die sich jedoch alleine auf den unsymmetrischen Verlauf der Spannung U gründen. Die Widerstandswerte für die beiden voll durchgeschalteten Schaltzweige 8a,b liegen bei je 20% gleich. Für eine alternative unterschiedliche Dimensionierung von Rc < Rb ergäbe sich z.B. der gestrichelt eingezeichnete Verlauf. Grund hierfür sind die unterschiedlichen Stromrichtungen I>0 und I<0 für Ein- und Ausschaltvorgang.

Die Widerstandsschaltung 2 kann in alternativen Ausführungsformen weitere oder weniger oder alternativ ausgestaltete parallel geschaltete Schaltzweige enthalten, die zu den dargestellten Schaltzweigen 8a,b alternativ dimensioniert sind. Auch können dann noch Schaltzweige vorhanden sein, die neben einem Widerstand nur eine Diode enthalten, um richtungsabhängig den Widerstandswert des immer wirksamen Durchflusszweiges 8a anzupassen.

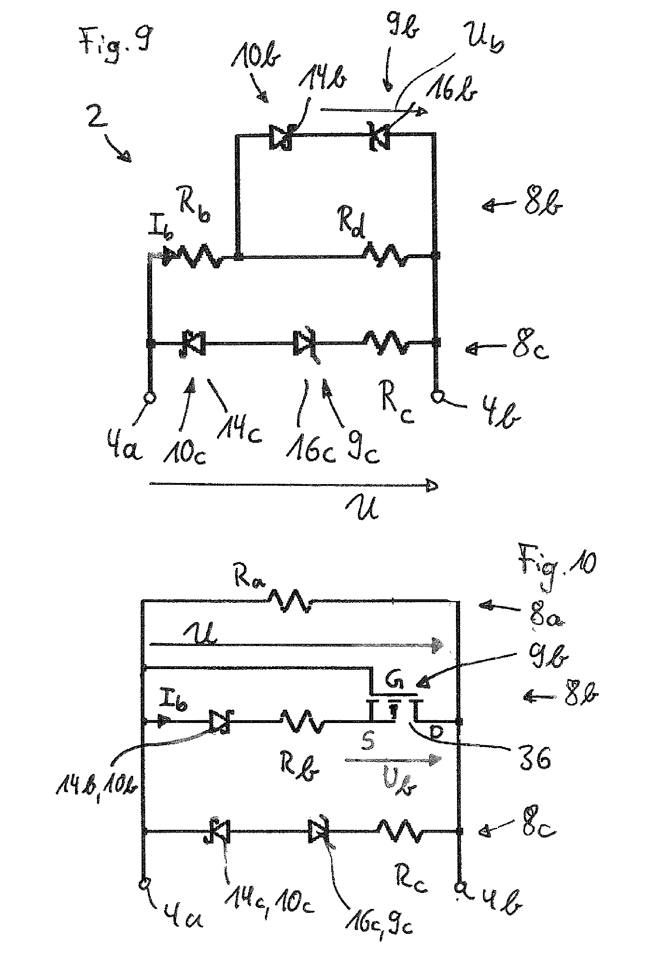

Fig. 9 zeigt daher eine gegenüber Fig. 1 topologisch abgeänderte Widerstandsschaltung 2, welche keinen Durchflusszweig 8a enthält. Der Schaltzweig 8b ist dafür alternativ ausgestaltet. Der Reihenschaltung aus Begrenzungselement 9b und Sperrelement 10b ist hier ein weiterer Widerstand Rd parallel geschaltet. Hierdurch entartet der Schaltzweig 8b im Grunde zu einem Durchlasszweig 8a, gemäß Fig. 1, welcher dann die Reihenschaltung der Widerstände Rb und Rd enthält und stets von einem Strom durchflossen ist. Dennoch enthält dieser Schaltzweig sowohl die Sperr- als auch die Begrenzungsfunktionalität, indem bei dem einem Stromfluss im Schaltzweig für Ströme Ib > 0 das Sperrelement 10b einen Stromfluss durch sich selbst und das Begrenzungselement 9b zulässt, sofern eine Teilspannung die über dem Begrenzungselement 9b abfällt, größer der diesem zugeordneten Grenzspannung Ub ist. Hier wirkt sich also die Grenzspannung Ub nicht auf die gesamte Spannung U über dem Widerstandselement 2, sondern nur auf eine entsprechend kleinere o.g. Teilspannung über dem Begrenzungselement 9b aus, welche jedoch zur Gesamtspannung U stets in einem bekannten Verhältnis steht und somit entsprechend dimensioniert werden kann.

Fig. 10 zeigt eine weitere Alternative, welche gegenüber der Widerstandsschaltung 2 aus Fig. 1 verändert ist. Hier ist der Durchflusszweig 8a und der Schaltzweig 8c identisch zu Fig. 1, der Schaltzweig 8b wiederum verändert. Verändert ist hier allerdings lediglich das Begrenzungselement 9b an sich, welches hier durch einen Transistor 36 gebildet ist. Dieser ist mit seinem Source- S und Drainanschluss D in Reihe zum Widerstand Rb in den Schaltzweig 8b eingebracht. Der Gateanschluss G ist auf die Anschlussklemme 4a und der Drainanschluss D gleichzeitig auf die Anschlussklemme 4b geführt. Auch das so ausgestaltete Begrenzungselement 9b definiert daher wieder eine Grenzspannung Ub. Im Gegensatz zu Fig. 1 ist hier jedoch ein Stromfluss Ib im Schaltzweig 8b für Spannungen U möglich, die kleiner der Grenzspannung Ub sind. Bei Überschreiten der Grenzspannung Ub sperrt der Transistor 36 und verhindert weiterhin einen Stromfluss im Schaltzweig 8b. Mit anderen Worten zeigt der Schaltzweig 8b aus Fig. 10 ein inverses Verhalten zum Schaltzweig 8b aus Fig. 1.

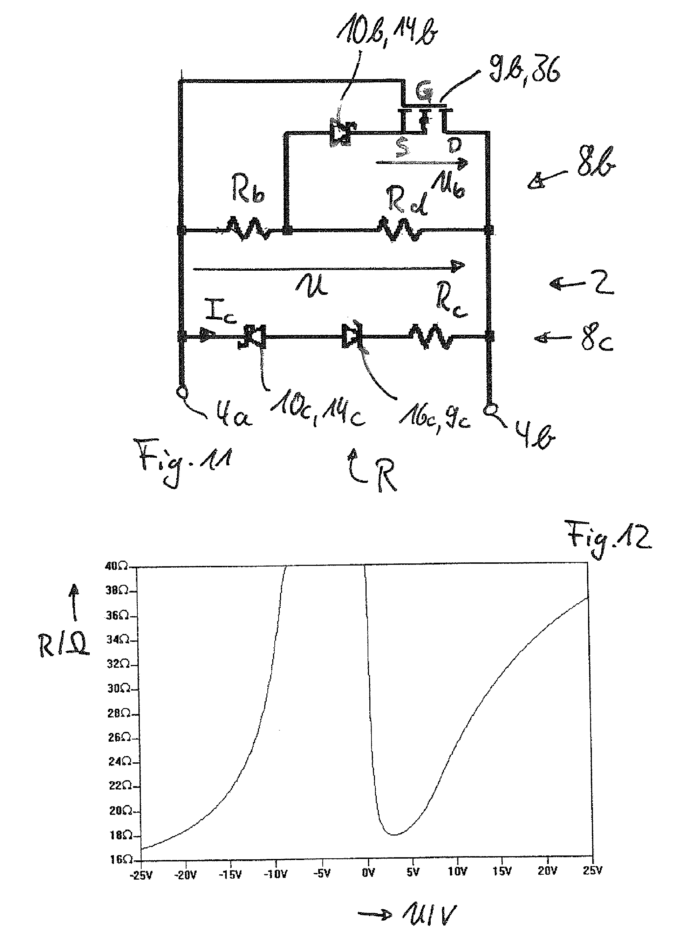

Fig. 11 zeigt wiederum eine entsprechende topologische Wandlung der Widerstandsschaltung 2 aus Fig. 9. Auch hier ist im Schaltzweig 8b das Begrenzungselement 9b durch einen Transistor 36 ersetzt. Der Widerstand Rd ist hier wieder der Reihenschaltung aus Sperrelement 10b und Begrenzungselement 9b parallel geschaltet. Gegenüber Fig. 9 gibt sich in Analogie zu Fig. 10 ein inverses Schaltverhalten des Schaltzweiges 8b.

Ansonsten gilt hier das entsprechend für Fig. 9 gesagte.

Im Gegensatz zu Fig. 9 ist jedoch die dem Begrenzungselement 9b zugeordnete Grenzspannung Ub wiederum mit der gesamten Spannung U zwischen den Anschlüssen 4a, b direkt korreliert, weil wiederum das Gate G des Transistors 36 auf den Anschluss 4a und das Drain D auf den Anschluss 4b geführt ist.

Fig. 12 zeigt für die Widerstandsschaltung 2 aus Fig. 11 den gesamten, zwischen den Klemmen 4a, b gemessenen Widerstand R gegenüber der über diesen Klemmen abfallenden Spannung U. Zu erkennen ist hier insbesondere im Bereich zwischen 0 und -10V die Wirkung der Parallelschaltung der Widerstände Rb und Rd von zusammen 40Ω im Schaltzweig 8b, da hier insbesondere das Sperrelement 10b generell einen Stromfluss durch das Begrenzungselement 9b verhindert, so dass dieses nicht wirkt sowie das Sperrelement 10c zwar prinzipiell einen Strom Ic < 0 fließen ließe, das Begrenzungselement 9c etwa jedoch erst ab einer Spannung von -10 V einen Stromfluss durch den Schaltzweig 8c erlaubt. Für Spannungen U > 0V hingegen ist der gesamte Schaltzweig 8c wegen des Sperrelements 10c blockiert, d.h. für den Gesamtwiderstand unwirksam, über das Sperrelement 10b ist jedoch das Begrenzungselement 9b zunächst wirksam und dieses in Form des Transistors 36 selbst leitend. Hier wirkt alleine der Widerstand Rb von 18Ω, wobei der Widerstand Rd zunächst im Sinne einer Bypass-Schaltung überbrückt ist. Erst ab einer Grenzspannung Ub von etwa 3V beginnt das Begrenzungselement 9b zu wirken und begrenzt allmählich den Stromfluss, welcher als Bypass des Widerstandes Rd wirkt, so dass dieser zunehmend seine Wirkung in Reihe zu Rb entfaltet.

## Patentansprüche

1. Widerstandsschaltung (2),
- mit zwei Anschlussklemmen (4a,b) und einer zwischen diesen anliegenden Spannung (U), und
- mit mindestens zwei, zwischen den Anschlussklemmen (4a,b) parallel geschalteten, jeweils mindestens einen ohmschen Widerstand (Ra-c) enthaltenden Zweigen (6a-c), bei der
- mindestens einer der Zweige (6a-c) als selbstschaltender Schaltzweig (8b,c) ausgebildet ist, der
- ein in Reihe zum Widerstand (Ra-c) geschaltetes, selbstschaltendes Begrenzungselement (9b,c) enthält, das einen Stromfluss für eine Spannung unterhalb oder oberhalb einer dem Schaltzweig (8b,c) zugeordneten Grenzspannung (Ub,c) verhindert, und
- der Schaltzweig (8b,c) ein in Reihe zum Widerstand (Ra-c) geschaltetes Sperrelement (10b,c) enthält, das einen Stromfluss entgegen einer Flussrichtung (12b,c) im Schaltzweig (8b,c) verhindert.

2. Widerstandsschaltung (2) nach Anspruch 1, bei der dem Begrenzungselement (9b,c) ein ohmscher Widerstand (Ra-c) parallel geschaltet ist.

3. Widerstandsschaltung (2) nach Anspruch 1 oder 2, bei der dem Begrenzungselement (9b,c) oder dem Sperrelement(10b,c) oder deren Reihenschaltung ein ohmscher Widerstand (Ra-c) parallel geschaltet ist.

4. Widerstandsschaltung (2) nach einem der vorhergehenden Ansprüche, mit mindestens zwei Schaltzweigen (8b,c), die bezüglich der Anschlussklemmen (4a,b) gegensinnig orientierte Flussrichtungen (12b,c) aufweisen.

5. Widerstandsschaltung (2) nach einem der vorhergehenden Ansprüche, bei der das Begrenzungselement (9b,c) eine die Grenzspannung (Ub,c) durch ihre Zenerspannung bestimmende Zenerdiode (16b,c) ist.

6. Widerstandsschaltung (2) nach einem der vorhergehenden Ansprüche, bei der das Begrenzungselement (9b,c) ein die Grenzspannung (Ub,c) bestimmender selbstleitender Transistor (36) ist.

7. Widerstandsschaltung (2) nach einem der vorhergehenden Ansprüche, bei der mindestens einer der Zweige (6a-c) ein stets einen Stromfluss erlaubender Durchflusszweig (8a) ist.

8. Widerstandsschaltung (2) nach einem der vorhergehenden Ansprüche, die als monolithisch integrierter Halbleiterchip ausgeführt ist.

9. Schaltungsanordnung (18),
- mit einem Eingang (20) und zwei Ausgängen (22a,b), und mit einem mit einem Emitter (E) an dem einen und einem Kollektor (K) an dem anderen der Ausgänge (22a,b) angeschlossenen Transistor (24), und
- mit einer zwischen einem Steuereingang (26) des Transistors (24) und dem Eingang (20) angeschlossenen Widerstandsschaltung (2) gemäß einem der Ansprüche 1 bis 8.

10. Schaltungsanordnung (18) nach Anspruch 9, bei der der Transistor (24) ein Leistungshalbleiterschalter ist.

11. Schaltungsanordnung (18) nach einem der Ansprüche 9 bis 10, deren Transistor (24) als erster Transistor mit einem zweiten Transistor parallel oder nach Art einer Halbbrücke verschaltet ist.

12. Treiber (28) für einen Leistungshalbleiterschalter (32),
- mit einem, mit einem Steuereingang (26) des Leistungshalbleiterschalters (32) verbindbaren Steuerausgang (30), mit einer dem Steuerausgang (30) vorgeschalteten Widerstandsschaltung (2) gemäß einem der Ansprüche 1 bis 8.
